# EUROPEAN PATENT APPLICATION

(11) **EP 0 655 776 A1**
(43) Date of publication of application: **31.05.1995**
(21) Application number: 93830480.5
(22) Date of filing: 30.11.1993
(51) Int. Cl.: H01L 21/314, H01L 21/768

(54) **Autoplanarizing process for the passivation of an integrated circuit**

(71) Applicant: SGS-THOMSON MICROELECTRONICS S.r.l., I-20041 Agrate Brianza (Milano) (IT)
(72) Inventor: Cereda, Manlio Sergio, I-20050 Lomagna (MI) (IT); Daffra, Stefano, I-20137 Milano (IT); Stucchi, Elena, I-20047 Brugherio (MI) (IT)

(57) **Abstract**

In a passivating method using silicon oxidonitride, prior to forming that layer (10), the surface is planarized by overlying the circuit structures (2,3) with at least a first layer (8) of a dielectric material, and on top of this, a second layer (9) of a dielectric material. The layers have such thickness dimensions as to ensure planarization of the top surface. In addition, the invention may be used with a passivation method without oxidonitride wherein the underlying morphology is also planarized by forming those same dielectric layers.

## Description

This invention relates to processes for forming planarized dielectric layers in the manufacture of monolithic integrated circuits, and primarily to methods for passivating an integrated circuit wherein layers of silicon oxidonitride have been specifically formed.

It is known that dielectric material layers, either interposed as inter-metal passivation layers between conductive layers or provided as final passivation coats over the last metallization layer, serve a dual function of electric insulation and of protection for the underlying structures of the integrated circuit from contaminants (impurities, moisture) or shocks.

It is common practice in the pertinent art to assemble integrated circuits within plastics packages on account of these being economically more favorable. Most EPROM (Erasable Programmable Read-Only Memory) volatile storages, whether non-erasable such as OTP (One Time Programmable) EPROMs or electrically erasable ones (EEPROMs, Flash EEPROMs), come indeed encapsulated within plastics materials.

These devices must be provided better resistance to moisture and contamination from outside sources than products which are assembled within ceramic packages inherently affording adequate protection. The porous nature of plastics materials makes them pervious to impurities and moisture, in fact. Additionally, the circuit assembly process. which includes heat application, followed by cooling, to the resin comprising the package and consequent release of moisture therefrom, does favor the intrusion of water into the circuits. Any water coming in contact with the conductive layers may corrode them or at least make the integrated circuit unstable and imperil its operation.

As the persons of skill in the art are well aware, the most suitable material to provide such protection is silicon oxidonitride (SixOyNz), wherein the elements may be present in varying proportions, and which in the extreme instance of oxygen being altogether absent, would become silicon nitride, Si3N4.

Oxidonitride is endowed with excellent imperviousness and retains good UV transmissivity, which properties allow it to be used for UV erasable storages. Accordingly, it is common pratice to use it in the final passivation layer.

On the other hand, the oxidonitride in film form is characterized by poor step coverage, i.e. low ability to spread smoothly over so-called stepped surfaces and thereby thoroughly cover the underlying surface and retain a conforming pattern with the structure beneath. It is therefore prone on breakage at the morphologically most critical points of the circuit, where uneven spots are apt to appear in its thickness. Such breakage may be promoted, moreover, by strain from external forces, as is likely to occur during the cutting process of the chip on which the circuit is fabricated for mounting to a holder. Any areas where the layer is cut or caused to part from the circuit structures it ought to protect, are bound to admit moisture into the structures, thereby harming the quality of the passivation.

As the skilled ones are well aware, to ensure good passivation of devices assembled within plastics packages, two-layer process schemes have long been adopted in practice whereby the oxidonitride is associated with PSG (Phosphorus Silicon Glass), a silicon oxide doped with phosphorus. PSG forms a good barrier to contamination, mainly from sodium, and is adequately impervious.

In past practice, the oxidonitride used to be placed directly over the circuit structures to be insulated. This layer was then overlaid with a coat of PSG. The latter acts to protect the oxidonitride, which is crumbly in nature, against scratches, such as may harm its integrity and occur during the final device encapsulating steps, for example. A major problem with that arrangement is that the oxidonitride deposited directly over the circuit structures is generally to rest on a fairly irregular contour surface. Thus, the oxidonitride develops weakening spots which may readily crack. This problem may result in the device failing to pass its Pressure Pot Test (PPT). With the current trend toward increased miniaturization of the circuits, the problem is made more serious by the denser structures and attendant reduced spacing of the metallizations, as well as by the larger number of conductive levels. Such trend does involve an expansion of the critical areas.

It has been shown experimentally that in order to improve the reliability of EPROM storage cells encapsulated within plastics packages under vapor stress, it is of paramount importance that the passivation layer ability to cover and seal off the underlying structures be significantly enhanced. These findings have been confirmed by I.S. Gaeta and K.J. Wu in an article "Improved EPROM moisture performance using Spin-On Glass (SOG) for passivation planarization", IEEE/IRPS, 1989, pages 122-126.

In this direction, the passivation technology efforts are mostly aimed at making the oxidonotride substrate as planar as possible. In prior art methods, as disclosed in the above-referenced article, a resin, specifically SOG (Spin-On Glass) has been used for planarization purposes which is a sacrificial organic polymer material commonly used as a planarizer in several steps of the integrated circuit manufacturing process. With that technique, the oxidonitride potential breakage spots can be minimized because it is no longer subjected to stresses from the underlying structure.

The net outcome is a passivation with greatly improved coverage. Devices on which it had been used have performed successfully on wet testing.

However, with the above method, the improved passivating efficiency is paid for by increased complexity, and this reflects unfavorably on production costs.

It is an object of this invention to provide a passivation method of low complexity, but affording a good degree of reliability, especially in the instance of plastics packaged integrated circuits and more particularly of those ICs whose passivation provides for an oxidonitride layer.

Another object, closely related to the one above, is to lower the cost of devices to be implemented using that technique.

A further object is to provide such a method which can be readily applied to other passivation steps as well.

According to the invention, in a passivation method using silicon oxidonitride, prior to forming this layer, the surface is planarized by overlying the circuit structures with at least a first layer of a dielectric material topped by a second (optional but provided in the preferred embodiment) layer of a dielectric material. The layers have thicknesses effective to ensure planarization of the top surface. The method may be applied in particular to circuits enclosed within plastics packages. This passivation may also be used, however, with devices not encapsulated in plastics packages, possibly without forming the final layer of oxidonitride. According to the invention, moreover, in a method of intermetal passivation, prior to forming a metallization layer, the underlying morphology is planarized, again by formation of the same dielectric layers as above.

The invention and its advantages will be more clearly apparent from a detailed description of a specific method based on its principle, as given herein below by way of non-limitative example with reference to the accompanying drawings, in which: Figure 1 is a sectional view of structures which have been integrated using a conventional passivation scheme; Figure 2 is a sectional view of the same structures as integrated using a passivation scheme with conventional planarization; and Figure 3 is a sectional view of the same structures as integrated using a passivation scheme according to one embodiment of this invention.

In the drawing figures, integrated structures to be insulated, shown at 2 and 3, are formed on the surface of a body of a semiconductor material 1, such as monocrystalline silicon. These may be storage cells of the high-density EPROM type, and are shown identical through all the drawing views for convenience of illustration. The layers 3 represent metallization paths. The latter require to be thoroughly insulated, and constitute the roughest regions on the circuit surface.

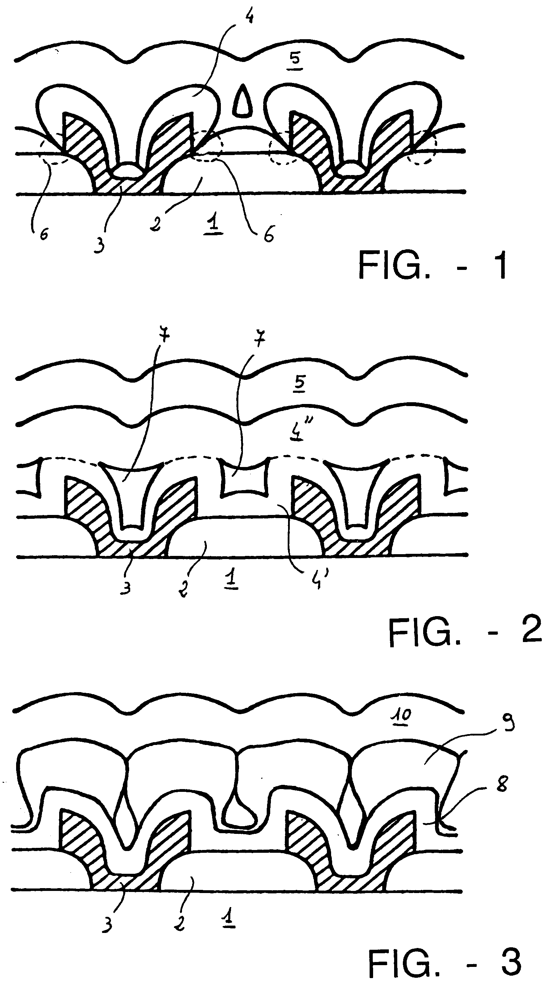

The most basic of passivations using oxidonitride is that shown schematically in Figure 1. A layer 4 of oxidonitride is formed directly over the structures. The top layer 5 is usually comprised of PSG. As can be seen in the figure, the oxidonitride shows slendering areas in its thickness at the bottom of the metallization levels (hatched areas 6) due to very poor coverage, which would bring about the previously outlined problems.

Passivation of this circuit structure with SOG planarization added is illustrated in Figure 2 and described in the aforementioned article, for example. The passivation step is commenced by first forming an oxidonitride layer 4' directly over the circuit structure. The whole surface is then covered with SOG; the layer formation is typically effected by depositing the material in liquid form onto the circuit and then causing it to spread evenly by spinning the chip that carries the circuit, in accordance with a well known technique. The SOG will fill the deeper areas completely and make its top surface planar. A subsequent plasma etching step will only leave SOG residue (shown at 7 in the drawing figure) to fill the gaps between upstanding structures.

This material must be then allowed to cure under heat application. Over the planarized morphology, a second layer 4'' of oxidonitride may be deposited. Thereafter, a protective finishing layer 5 of PSG is deposited. The oxidonitride forming the single layer 4'-4'' is now planarized, and no breakages will occur during passivation. Although effective, this technique comprises a significantly large number of processing steps.

Illustrated in Figure 3 is a passivation method using oxidonitride according to a preferred embodiment of this invention. The passivating step includes formation of the oxidonitride only after the surface with which it is to come in contact has been planarized. Planarization is carried out by forming layers of dielectric materials over the circuit structures 2, 3. In an improved embodiment of the invention, the passivating step begins with the formation of a layer 8 of a dielectric material. It should be noted that, while the dielectric 8 has been shown as a single layer in the drawing figure, this could actually include a number of superimposed layers. Subsequently in the preferred process, a second layer 9 of a dielectric material is formed on top of this which may also consist of multiple layers. This second dielectric material, in accordance with the invention, so spreads out as to produce a planarized free surface of the layer 9. This stage of the process may be followed by the formation of the silicon oxidonitride layer 10 to thereby complete the passivation. The oxidonitride overlies, according to the invention, a flat morphology and undergoes, therefore, no stresses during its deposition. Planarization is ensured, in the preferred embodiment, by the provision of both dielectric layers. The first layer is effective to narrow the gaps between any two adjacent structures in the circuit, the metallization paths in the example shown. In this way, the morphology of the circuit surface is initially made smooth. The second layer completes the planarization by providing a sufficient thickness to produce a substantially planar top surface.

It should spread out so as to meet over the areas between circuit structures, representing morphologic depressions, and seal them off at least upwardly. The film features need not be such that it will fill the areas between structures completely. As shown in Figure 3, some voids may be left in the depressions. To achieve true planarity, a careful selection of the dielectric thickness dimensions is instead essential. Such thickness dimensions are closely tied to the dimensions of the device. In the specific instance of EPROM storages, account should be taken of the architecture of the individual cells, the metal-to-metal distance, and the metal-on-contact overlap. Proper consideration should also be given to the processing steps which precede passivation and affect the circuit structure shape, such as the metal profile after etching and the shape of the underlying dielectric. Optimum thickness dimensions can be found by calculation for individual devices.

In a preferred embodiment, the first layer comprises deposited oxide, usually undoped silicon dioxide. The latter is known in the art as USG (Undoped Silicon Glass). This formation is obtained using a conventional CVD (Chemical Vapor Deposition) technique. The layer properties will depend on the technique used, in particular on such physical parameters as deposition pressure and temperature, on the one side, and its chemical precursors, on the other. A film having satisfactory step coverage properties to ensure conformity with the underlying circuit structure is preferred, although this is no essential prerequisite.

The better the step coverage property, the lesser will be the layer thickness needed to reduce the gaps between adjacent structures, in fact.

Preferably, the second dielectric comprises instead a doped oxide, in particular silicon oxide doped with phosphorus, namely PSG, which is commonly deposited using a CVD technique. As previously mentioned, it has been used in the prior art for final passivation purposes, as well as in other insulating operations during the manufacture of an integrated circuit, because of its capability to form a barrier to contaminants. In the process of this invention, PSG represents a good choice for the second dielectric material. In fact, it can spread out over the roughest of morphologies in a non-conforming but profile-smoothing fashion. The film properties, in particular its capability to conform, are defined by the deposition method and specifically by its phosphorus content, with a higher phosphorus content resulting in reduced step coverage.

On the other hand, the dopant content should be lower than 7% to prevent incidental formation, due to moisture penetration, of phosphoric acid which would attack the metallizations. Preferably, the amount used in this invention is in the 5% range, which agrees with the prior art.

In practice, passivation is best provided by the first or filler layer, having a smaller thickness than the second which is intended to provide planarization properly. A ratio of the two dielectrics in the range of about 1:2 represents a good value for this invention and is applicable to several products. With devices and architectures currently employed today, where a dual layer of USG-PSG is used, optimum thicknesses for these dielectrics are 5000 Angstroms for USG and 8000 Angstroms for PSG.

To form the oxidonitride, conventional techniques may be used which are available from literature and need not be discussed in detail herein. This is customarily deposited, as is well known to the skilled ones, in a PECVD (Plasma Enhanced CVD) reactor.

It should be noted that the absence of a protective top coat on the oxidonitride -- as is instead provided in the prior art (the PSG layer itself being used for the purpose) -- does not harm the device performance because the likelihood of the passivation integrity becoming affected is quite small. The mere reversal in the formation of the PSG and oxidonitride layers provided by the invention, on the other hand, allows the same combination of dielectric materials to be used which has long proved effective to form a barrier to external agents.

The reliability of the passivation process described above has been demonstrated experimentally in the course of wet tests.

It has proved excellent for devices enclosed in plastics packages.

The effectiveness of this solution is quite high for structures to be passivated whose morphologies include fairly closely spaced elevations. In such cases, in fact, the PSG layer would better cover the depressions without suffering breakages. In view of the trend toward increased miniaturization, and hence denser structures, in today's technology, the invention can be used to even greater advantage.

The method of this invention has an additional advantage in that it is uncomplicated.

The number of its processing steps can be small, in the extreme as small as three, i.e. just the dielectric and oxidonitride layer depositions. Furthermore, it may be called "self-planarizing" in the sense that no external arrangements are required for planarizing the passivation layers. No sacrificial materials are used, the formation and subsequent etching whereof would contribute, inter alia, to the process complexity. On this account, the production cost of devices processed with this method can be kept low.

Additionally, the procedures and materials used are those already known in the art, so that no special equipment must be made available to implement the invention.

It may be appreciated that the embodiment form described in detail hereinabove, in connection with devices assembled within plastics packages requiring passivation with oxidonitride, may be adapted for passivation without oxidonitride by merely omitting the final step of oxidonitride formation.

The method of this invention may also be applied, in another preferred embodiment thereof, to the intermetal passivation step. The planarizing dual layer would be similar to the one described, except that a metallization layer would be formed on top after exposing the contacts by etching away the dielectrics.

Furthermore, successive metallization levels may be formed sequentially to both encompass the planarized passivation of this invention and an overlying conductor layer. Each metallization level would then be made available a planarized dielectric substrate of its own. This would be an excellent form of passivation for plastics packaged circuits as well.

It could be used, for example, in combination with the previous embodiment, with the oxidonitride only formed over the last metallization level.

Finally, it should be appreciated that in applications of the present invention, the planarizing dielectric layers may be reduced to just one, having a thickness equal to the combined thicknesses of the two dielectric layers. It could either be a single layer of PSG or USG.

In the extreme, the dielectric layers for planarization could be only provided in the morphologically most critical areas.

## Claims

1. A self-planarizing method for passivating with silicon oxidonitride an integrated circuit defined on a surface of a body of semiconductor material, comprising the formation of a silicon oxidonitride layer over integrated structures of said circuit, characterized in that, prior to forming said silicon oxidonitride layer, at least a first layer of a dielectric material is formed over at least portions of said structures, the thickness of said layer being adequate to produce a top surface of the layer which is smooth and substantially planar.

2. A method according to Claim 1, characterized in that the first layer of dielectric material is a silicon oxide.

3. A method according to Claim 2, characterized in that the silicon oxide is doped with phosphorus (PSG, Phosphorus Silicon Glass).

4. A self-planarizing method for passivating with silicon oxidonitride an integrated circuit defined on a surface of a body of semiconductor material, comprising the formation of a silicon oxidonitride layer over integrated structures of said circuit, characterized in that, prior to forming said silicon oxidonitride layer, a first layer of a dielectric material is formed over at least portions of said structures and at least a second layer of a dielectric material is formed over at least part thereof, the combined thickness of the layers being adequate to produce a top surface of the second layer which is smooth and substantially planar.

5. A method according to Claim 4, characterized in that the first and second layers of dielectric material comprise silicon oxides.

6. A method according to Claim 5, characterized in that the first oxide layer comprises undoped silicon oxide (USG, Undoped Silicon Glass).

7. A method according to either Claim 5 or 6, characterized in that the second oxide layer is a silicon oxide doped with phosphorus (PSG).

8. A method according to Claim 7, characterized in that the amount of phosphorus is about 5%.

9. A method according to any of Claims 4, 5, 6, 7 or 8, characterized in that the thickness of the second layer is approximately twice that of the first layer.

10. A method according to Claim 9, characterized in that the thicknesses of the first and second layers are about 5000 and 8000 Angstroms, respectively.

11. A self-planarizing method for passivating with silicon oxidonitride an integrated circuit defined on a surface of a body of semiconductor material, characterized in that it comprises the steps of forming, over at least portions of integrated structures of said circuit, at least a first layer of a dielectric material, and at least a second layer of a dielectric material over at least part thereof, the combined thickness of the layers being adequate to produce a top surface of the second layer which is smooth and substantially planar.

12. A method according to Claim 11, characterized in that the first and second layers of dielectric material comprise silicon oxides.

13. A method according to Claim 12**,** characterized in that the first oxide layer comprises silicon oxide (USG) undoped with other elements.

14. A method according to either Claim 12 or 13, characterized in that the second oxide layer is a silicon oxide (PSG) doped with phosphorus.
